(19) Europäisches Patentamt

European Patent Office

Office européen des brevets

(11) EP 0 877 947 B1

(12) **EUROPÄISCHE PATENTSCHRIFT**

(45) Veröffentlichungstag und Bekanntmachung des Hinweises auf die Patenterteilung:
**31.07.2002 Patentblatt 2002/31**

(21) Anmeldenummer: 97914092.8

(22) Anmeldetag: **24.01.1997**

(51) Int Cl.⁷: **G01R 31/08**, G01R 27/16

(86) Internationale Anmeldenummer:
**PCT/DE97/00159**

(87) Internationale Veröffentlichungsnummer:
**WO 97/28452 (07.08.1997 Gazette 1997/34)**

(54) **VERFAHREN ZUR BILDUNG EINES RESISTANZWERTES**

METHOD OF CALCULATING A RESISTANCE

METHODE DE CALCUL D'UNE RESISTANCE

(84) Benannte Vertragsstaaten:
**DE FR GB IT**

(30) Priorität: **31.01.1996 DE 19605013**

(43) Veröffentlichungstag der Anmeldung:
**18.11.1998 Patentblatt 1998/47**

(73) Patentinhaber: **SIEMENS AKTIENGESELLSCHAFT**
**80333 München (DE)**

(72) Erfinder: **JURISCH, Andreas**
**D-13587 Berlin (DE)**

(56) Entgegenhaltungen:
**DE-A- 2 551 472**          **US-A- 3 984 737**

**Beschreibung**

Die Erfindung bezieht sich auf ein Verfahren zur Bildung des Resistanzwertes einer Impedanz einer durch einen Fehler auf einem zu überwachenden Abschnitt einer wechselstromdurchflossenen elektrischen Energieversorgungsleitung gebildeten Leiter-Schleife, bei dem in einem Zeitintervall abgetastete Augenblickswerte des gemessenen Stromes und der gemessenen Spannung herangezogen werden.

Ein derartiges Verfahren ist aus der EP 0 284 546 A bekannt. Darin werden Augenblickswerte des Stromes und der Spannung abgetastet und in einer digitalen Filtereinheit bewertet, die aus mehreren linearphasigen nichtrekursiven digitalen FIR-Filtern eines ersten Typs und eines zweiten Typs besteht. Die bewerteten Augenblickswerte werden in Differentialgleichungen erster Ordnung eingesetzt. Diese Differentialgleichungen werden anschließend zur Bildung eines Resistanzwertes herangezogen. Aus der EP 0 284 546 läßt sich ferner entnehmen, daß bei einer Abtastperiode von 1 ms und für Wechselstrom mit einer Schwingungsperiode von 20 ms zur schnellen und ausreichend genauen Ermittlung des Resistanzwertes insgesamt 13 Augenblickswerte des Stromes bzw. der entsprechenden Spannung zu bewerten sind (Seite 4, Zeilen 7 bis 11 und Seite 9, Zeilen 45 bis 47). Diese Anzahl der Augenblickswerte ergibt sich aus einem gewählten Zählergrad n=8 und aus einem zeitlichen Abstand von ungefähr ¼ Netzperiodendauer (5 ms), der bei der Abtastung linear unabhängiger Augenblickswerte einzuhalten ist. Es werden also 13 ms für die Abtastung der Augenblickswerte benötigt.

Der Erfindung liegt die Aufgabe zugrunde, bei einem Verfahren der eingangs erwähnten Art die zur Bildung des Resistanzwertes benötigte Zeit im Vergleich zum bekannten Verfahren zu reduzieren, ohne dabei erheblich ungenauer zu werden.

Die Lösung der gestellten Aufgabe erfolgt erfindungsgemäß bei einem Verfahren der eingangs erwähnten Art, indem

-   während einer halben Periode des Wechselstromes abgetastete Augenblickswerte des Stromes und der Spannung erfaßt werden,
-   aus den erfaßten Augenblickswerten des Stromes und der Spannung Augenblickswerte einer Leistung berechnet werden und daraus durch Integration ein der Wirkleistung proportionaler Wert ermittelt wird,
-   die erfaßten Augenblickswerte des Stromes quadriert und ein Integral der quadrierten Augenblickswerte des Stromes ermittelt wird und
-   der Resistanzwert aus dem der Wirkleistung proportionalen Wert und dem Wert des Integrals der quadrierten Augenblickswerte des Stromes durch Quotientenbildung erzeugt wird.

Es ist zwar aus der deutschen Offenlegungsschrift DE-A-25 51 472 A1 eine Vorrichtung zum Prüfen von Widerstandsschweißgeräten bekannt, bei der durch Quotientenbildung aus einer der Wirkleistung proportionalen Meßzwischengröße und einer dem Effektivwert eines Stromes proportionalen weiteren Meßzwischengröße ein Resistanzwert gewonnen wird, jedoch gibt dieser Wert den Resistanzwert eines Schweißkabels des Widerstandsschweißgerätes an; zur Gewinnung der beiden Meßzwischengrößen werden der Strom durch das Schweißkabel und der Spannungsabfall an diesem Kabel als analoge (sinusförmige) Größen erfaßt und weiterverarbeitet. Dabei wird der Strom nach Integration einerseits einem Quadrierer mit nachgeordnetem Integrator und andererseits gemeinsam mit dem Spannungsabfall einem Multiplizierer mit nachgeschalteter Integratorschaltung zugeführt. Am Ausgang der Integratorschaltung ergibt sich dann die eine Meßzwischengröße, während am Ausgang des Integrators die weitere Meßzwischengröße ansteht. Wegen der Verarbeitung analoger Größen benötigt die bekannte Vorrichtung eine Meßzeit zur Bildung des Resistanzwertes von mindestens einer Periode des Stromes durch das Schweißkabel.

Der wesentliche Vorteil bei dem erfindungsgemäßen Verfahren liegt darin, daß es zur Ermittlung des Resistanzwertes aus mathematischen Gründen genügt, die Augenblickswerte nur während einer halben Periode der Wechselstromschwingung zu erfassen, d. h., daß bei einer Schwingungsperiode von 20 ms nur noch 10 ms zum Erfassen der Augenblickswerte benötigt werden. Das erfindungsgemäße Verfahren macht sich die Eigenschaft des Wechselstromes zunutze, wonach der Strom und die entsprechende Spannung mit folgenden Sinusfunktionen beschrieben werden können:

$$I(t) = \sqrt{2} \cdot I \sin(\omega t + \varphi)$$

$$U(t) = \sqrt{2} \cdot U \sin(\omega t).$$

Dabei sind I und U die Effektivwerte von Strom und Spannung, $\omega$ die Kreisfrequenz der Netzschwingung und $\varphi$ die Phasendifferenz zwischen I(t) und U(t).

Das Produkt des Stromes mit der Spannung ergibt folgende Gleichung:

$$I(t) \cdot U(t) = \sqrt{2} \cdot I \sin(\omega t + t) \cdot \sqrt{2} \cdot U \sin(\omega t).$$

Nach Umformung erhält man

$$I(t) \cdot U(t) = UI \cos \varphi - UI \cos (2\omega t + \varphi).$$

Das rechte Glied dieser Gleichung enthält einen Kosinus mit der doppelten Netzschwingungsfrequenz $2\omega$. Der obengenannte Vorteil ergibt sich daraus, daß bei einer Integration des Produkts $I(t) \cdot U(t)$ über eine Zeitperiode $T_{2\omega}$, die einer halben Netzschwingungsperiode entspricht, die Werte des Kosinus mit der doppelten Netzschwingungsfrequenz sich zu Null addieren. Es wird folgender zur Wirkleistung $P = UI \cos \varphi$ proportionale Wert erhalten:

$$\int_{T_{2\omega}} U(t) \cdot I(t)dt = \frac{\pi}{\omega} UI \cos \varphi \qquad (1)$$

Andererseits kann die Wirkleistung $P$ in bekannter Weise auch mit folgender Gleichung berechnet werden:

$$P = I^2 R.$$

Dabei ist $R$ der Resistanzwert.

Zur Berechnung wird das Quadrat der Augenblickswerte des Stromes benötigt. Dazu wird die Integration quadrierter Augenblickswerte des Stromes über den Zeitraum $T_{2\omega}$ in folgender Gleichung berechnet:

$$\int_{T_{2\omega}} I^2(t)dt = 2I^2 \int_{T_{2\omega}} \sin^2(\omega t + \varphi)dt$$
$$= \frac{\pi}{\omega} I^2 \qquad (2)$$

Es folgt, daß der Resistanzwert $R$ aus den Werten der Gleichungen (1) und (2) ermittelt werden kann:

$$R = \frac{\int_{T_{2\omega}} U(t) \cdot I(t)dt}{\int_{T_{2\omega}} I^2(t)dt} \qquad (3)$$
$$= \frac{UI \cos \varphi}{I^2}$$

Das erfindungsgemäße Verfahren wird im folgenden anhand eines Ausführungsbeispiels und einer Figur erläutert.

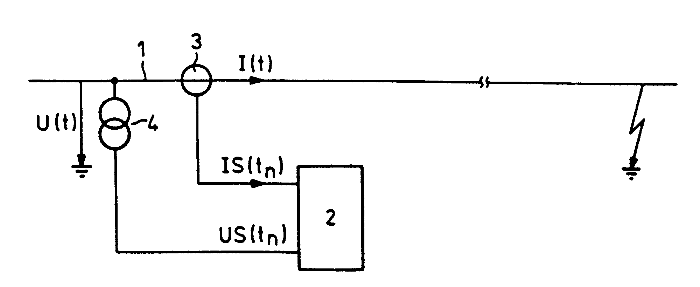

In der Figur ist eine Leiter-Schleife in Form einer mit einem Erdkurzschluß behafteten wechselstromdurchflossenen elektrischen Leitung 1 mit einer Anordnung 2 zur Durchführung des erfindungsgemäßen Verfahrens schematisch dargestellt.

Unter Berücksichtigung des grundsätzlichen Zusammenhangs (3) wird zunächst aus am Stromwandler 3 abgetasteten sekundären Augenblickswerten $IS(t_n)$ des Stromes $I(t)$ und aus am Spannungswandler 4 abgetasteten sekundären Augenblickswerten $US(t_n)$ der Spannung $U(t)$ der zur Wirkleistung proportionale Wert $P(t_n)$ ermittelt, wie

in folgender Gleichung erläutert wird:

$$P(t_n) = \sum_{k=0}^{9} US(t_{n-k}) \cdot IS(t_{n-k})$$

In dieser Gleichung steht auf der linken Seite der zur Wirkleistung proportionale Wert zum Zeitpunkt $t_n$. Auf der rechten Seite wird das Produkt des Augenblickswertes der sekundären Spannung mit dem Augenblickswert des sekundären Stromes, beide zur Zeit $t_{n-k}$ abgetastet, über Werte von k summiert. Die Summe enthält alle Augenblickswerte die zwischen $t_{n-9}$ und $t_n$ gemessen sind und entspricht einer Integration über einer halben Periode der Netzschwingung, wenn zehn Abtastungen pro halbe Periode vorgenommen werden.

Anschließend werden aus demselben Zeitraum $t_{n-9}$ bis $t_n$ gemessene Augenblickswerte des sekundären Stromes quadriert und aufsummiert:

$$I_{\Sigma}^2(t_n) = \sum_{k=0}^{9} IS^2(t_{n-k})$$

Die Zeit $t_n$ auf der linken Seite gibt wieder an, daß es sich bei der ermittelten Summe um einen Wert zur Gewinnung des Resistanzwertes zum Zeitpunkt $t_n$ handelt.

Der Resistanzwert wird durch Quotientenbildung des zur Wirkleistung proportionalen Wertes und der Summe der quadrierten Ströme folgendermaßen gebildet:

$$R(t_n) = \frac{P(t_n)}{I_{\Sigma}^2(t_n)}$$

Das erfindungsgemäße Verfahren kann vorteilhafterweise in einem Distanzschutzverfahren verwendet werden. Beispielsweise eignet es sich, um eine relativ schnelle Ermittlung der Resistanzkomponente einer Impedanz durchzuführen, damit diese Resistanzkomponente und ggf. eine weitere relativ schnell ermittelte Komponente der Impedanz dahingehend überprüft werden kann, ob sie innerhalb einer Auslösekennlinie liegt. Diese Auslösekennlinie kann beispielsweise ein symmetrisch und parallel zu einer Reaktanzachse beschnittener Kreis sein.

**Patentansprüche**

1. Verfahren zur Bildung des Resistanzwertes einer Impedanz einer durch einen Fehler auf einem zu überwachenden Abschnitt einer wechselstromdurchflossenen elektrischen Energieversorgungsleitung gebildeten Leiter-Schleife, bei dem in einem Zeitintervall abgetastete Augenblickswerte des gemessenen Stromes und der gemessenen Spannung herangezogen werden, **dadurch gekennzeichnet, daß**

   - während einer halben Periode des Wechselstromes abgetastete Augenblickswerte des Stromes ($IS(t_n)$) und der Spannung ($US(t_n)$) erfaßt werden,
   - aus den erfaßten Augenblickswerten des Stromes ($IS(t_n)$) und der Spannung ($US(t_n)$) Augenblickswerte einer Leistung berechnet werden und daraus durch Integration ein der Wirkleistung proportionaler Wert ermittelt wird,
   - die erfaßten Augenblickswerte des Stromes ($IS(t_n)$) quadriert und ein Integral der quadrierten Augenblickswerte des Stromes ermittelt wird und
   - der Resistanzwert aus dem der Wirkleistung proportionalen Wert und dem Wert des Integrals der quadrierten Augenblickswerte des Stromes durch Quotientenbildung erzeugt wird.

**Claims**

1. Method for forming the resistance value of an impedance of a conductor loop formed by a fault on a monitored section of an electric power supply line flowed through by alternating current, in the case of which instantaneous values, sampled in a time interval, of the measured current and the measured voltage are used, **characterized in that**

    - instantaneous values of the current ($IS(t_n)$) and of the voltage ($US(t_n)$) sampled during a half period of the alternating current are detected,
    - instantaneous values of a power are calculated from the detected instantaneous values of the current (($IS(t_n)$) and the voltage ($US(t_n)$), and a value proportional to the effective power is determined therefrom by integration,
    - the detected instantaneous values of the current ($IS(t_n)$) are squared and an integral of the squared instantaneous values of the current is determined, and
    - the resistance value is generated from the value proportional to the effective power and the value of the integral of the squared instantaneous values of the current by quotient formation.

**Revendications**

1. Procédé de formation de la valeur de résistance d'une impédance d'une boucle de conducteur formée par un défaut sur un tronçon à surveiller d'une ligne d'alimentation en énergie électrique parcourue par un courant alternatif et dans lequel on exploite des valeurs instantanées, échantillonnées dans un intervalle de temps, du courant mesuré et de la tension mesurée, **caractérisé par le fait que**

    - on relève des valeurs instantanées, échantillonnées pendant une demi-période du courant alternatif, du courant ($IS(t_n)$) et de la tension ($US(t_n)$),
    - à partir des valeurs instantanées relevées du courant ($IS(t_n)$) et de la tension ($US(t_n)$), on calcule des valeurs instantanées de la puissance et, à partir de là, par intégration, une valeur proportionnelle à la puissance active,
    - on élève au carré les valeurs instantanées relevées du courant ($IS(t_n)$) et on détermine une intégrale des carrés des valeurs instantanées du courant, et
    - on produit la valeur de résistance à partir de la valeur proportionnelle à la puissance active et de la valeur de l'intégrale des carrés des valeurs instantanées du courant en en formant le quotient.